# EUROPÄISCHE PATENTSCHRIFT

(11) **EP 1 030 367 B1**
(45) Veröffentlichungstag und Bekanntmachung des Hinweises auf die Patenterteilung: **04.05.2005**
(21) Anmeldenummer: 00102589.9
(22) Anmeldetag: 07.02.2000
(51) Int. Cl.: H01L 23/522, H01L 23/528

(54) **Integrierte Halbleiterschaltung mit stabilisierten Leiterbahnen**
Integrated semiconductor device with stabilized conductive lines
Dispositif semi-conducteur avec des lignes conductrices stabilisées

(30) Priorität: 19.02.1999 DE 19907127
(43) Veröffentlichungstag der Anmeldung: 23.08.2000
(73) Patentinhaber: Infineon Technologies AG, 81669 München (DE)
(72) Erfinder: Feurle, Robert, 85579 Neubiberg (DE); Schneider, Helmut, 80993 München (DE)
(74) Vertreter: Müller - Hoffmann & Partner

(56) Entgegenhaltungen:
- EP-A- 0 407 933
- EP-A- 0 692 824
- PATENT ABSTRACTS OF JAPAN vol. 1995, no. 06, 31. Juli 1995 (1995-07-31) -& JP 07 074176 A (SONY CORP), 17. März 1995 (1995-03-17)
- PATENT ABSTRACTS OF JAPAN vol. 1998, no. 11, 30. September 1998 (1998-09-30) -& JP 10 154808 A (TOSHIBA CORP), 9. Juni 1998 (1998-06-09)
- PATENT ABSTRACTS OF JAPAN vol. 1999, no. 07, 31. März 1999 (1999-03-31) -& JP 09 293721 A (LSI LOGIC CORP), 11. November 1997 (1997-11-11) -& US 6 109 775 A (PRABHAKAR TRIPATHI ET AL) 29. August 2000 (2000-08-29)
- PATENT ABSTRACTS OF JAPAN vol. 1999, no. 11, 30. September 1999 (1999-09-30) -& JP 11 154679 A (HITACHI LTD), 8. Juni 1999 (1999-06-08)
- PATENT ABSTRACTS OF JAPAN vol. 1996, no. 08, 30. August 1996 (1996-08-30) -& JP 08 097290 A (KAWASAKI STEEL CORP), 12. April 1996 (1996-04-12)

## Beschreibung

Die vorliegende Erfindung bezieht sich auf eine integrierte Halbleiterschaltungsanordnung mit in wenigstens zwei verschiedenen Ebenen verlaufenden Leiterbahnen, bei der in wenigstens einer der Ebenen Leiterbahnen in enger Nachbarschaft im wesentlichen parallel zueinander vorgesehen sind.

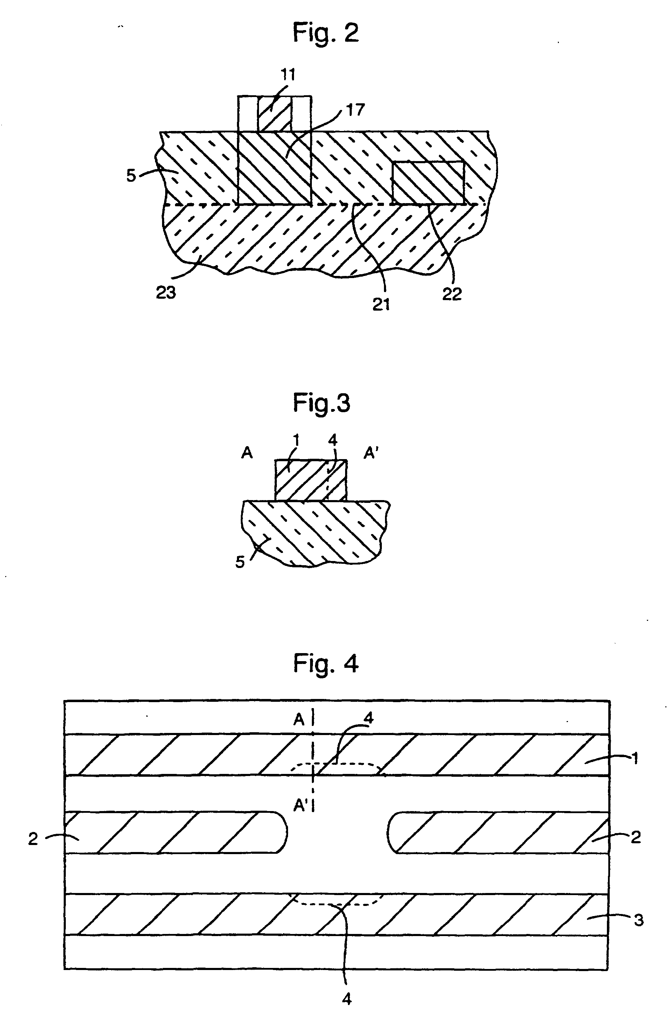

Bei der Herstellung von integrierten Halbleiterschaltungsanordnungen, wie beispielsweise Halbleiterspeichern, können, wenn beispielsweise Leiterbahnen eng benachbart parallel zueinander verlaufen und eine dieser Leiterbahnen unterbrochen ist, sogenannte Proximity- bzw. Nachbarschaftseffekte auftreten, die letztlich dazu führen, daß eine Leiterbahn in einem derartigen Bereich eine kritische Stelle zeigt, an welcher die Leiterbahn instabil werden kann und sogar zu einer Unterbrechung neigt. Dies soll anhand der Fig. 4 erläutert werden, in welcher eine Draufsicht auf drei Leiterbahnen 1 bis 3 gezeigt ist, von welchen die Leiterbahn 2 in ihrer Mitte unterbrochen ist. Diese Unterbrechung kann beispielsweise darauf beruhen, daß diese Leiterbahn 2 an ihren in der Fig. 4 gegenüberliegenden mittleren Enden über Kontakte mit einem Bauelement verbunden ist, das in einer anderen Metallisierungsebene liegt. Jedenfalls liegt aufgrund dieser Unterbrechung der Leiterbahn 2 für die Leiterbahnen 1 und 3 eine Diskontinuität in deren Nachbarschaft vor. Solche Diskontinuitäten treten insbesondere auch dann auf, wenn beispielsweise bei einem Halbleiterspeicher zwei zueinander benachbarte Leiterbahnen einander in einem Twist-Bereich überkreuzen. An diesen Twistbereich angrenzende weitere Leiterbahnen "sehen" dann die Diskontinuität des Twist-Bereiches.

Jedenfalls hat sich gezeigt, daß durch solche Diskontinuitäten benachbarte Leiterbahnen beeinträchtigt werden: liegt nämlich eine Diskontinuität vor, so können bei der Herstellung die benachbarten Leiterbahnen, also im vorliegenden Beispiel die Leiterbahnen 1 und 3, im Bereich der Diskontinuität einen verringerten Querschnitt haben, wie dies durch eine Strichlinie 4 für die Leiterbahn 1 bzw. 3 angedeutet ist.

Fig. 3 zeigt in einem Querschnitt A-A', wie sich diese Diskontinuität auf die Leiterbahn 1 auswirkt: die beispielsweise auf einer Isolierschicht 5 aus Siliziumdioxid verlaufende Leiterbahn 1 hat im Bereich der Diskontinuität der Leiterbahn 2 einen verringerten Querschnitt, der durch die Strichlinie 4 begrenzt ist.

Liegen nun solche Diskontinuitäten beidseitig von einer Leiterbahn vor, so kann eine solche Leiterbahn instabil werden und gegebenenfalls sogar abreißen.

Selbstverständlich sind derartige kritische Stellen in hohem Maße unerwünscht, weshalb an diesen Stellen oft die geometrischen Abmessungen der Leiterbahnen vergrößert werden. Ein derartiges Vorgehen hat aber den Nachteil, dass damit zwangsläufig die Leiterbahnen bzw. deren Abstände voneinander vergrößert werden, was der ständig angestrebten Miniaturisierung von integrierten Halbleiterschaltungsanordnungen entgegensteht.

Im Einzelnen ist aus dem Dokument JP-A-07074176 eine integrierte Halbleiterschaltungsanordnung bekannt, bei der Dummy-Kontaktlöcher zur Verbindung von Leiterbahnen zweier Leiterbahnebenen vorgesehen sind. Diese Dummy-Kontaktlöcher werden nämlich mit Leitermaterial gefüllt, um Leiterbahnen in den beiden Leiterbahnebenen miteinander zu verbinden.

Die JP-A-10159808 zeigt eine Halbleiterschaltungsanordnung, bei der Dummy-Leiterbahnen und Dummy-Kontaktlöcher vorhanden sind. Diese Dummy-Leiterbahnen und Dummy-Kontaktlöcher sollen zum Schutz von Gateoxid-Filmen beim Plasmaätzen denen. Aus der JP-A-08097290 ist eine Halbleiterschaltungsanordnung bekannt, bei der zur Reduzierung von Produktionsausfällen Dummy-Kontaktlöcher, Dummy-Kontakte und Dummy-Leiterbahnen vorhanden sind. Schließlich beschreibt die EP-A-0 692 624 eine Halbleiterschaltungsanordnung, welche Dummy-Durchgangslöcher vorsieht, über die Wärme von Leiterbahnen abgeführt wird.

Es ist Aufgabe der vorliegenden Erfindung, eine integrierte Halbleiterschaltungsanordnung anzugeben, bei der Instabilitäten von Leiterbahnen an kritischen Stellen und insbsondere Diskontinuitäten zuverlässig vermieden werden können.

Diese Aufgabe wird bei einer integrierten Halbleiterschaltungsanordnung mit in wenigstens zwei verschiedenen Ebenen verlaufenden Leiterbahnen, bei der in wenigstens einer der Ebenen Leiterbahnen in enger Nachbarschaft im Wesentlichen parallel zueinander vorgesehen sind, erfindungsgemäß dadurch gelöst, dass die Leiterbahnen an Diskontinuitäten wenigstens einer benachbarten Leiterbahn durch einen Dummy-Kontakt unterlegt sind. Die erfindungsgemäße integrierte Halbleiterschaltungsanordnung sieht also eine überraschend einfache Lösung des obigen Problems von Diskontinuitäten bzw. kritischen Stellen speziell infolge des Proximity-Effektes vor: an solchen Stellen werden die Leiterbahnen in einfacher Weise durch einen Dummy-Kontakt unterlegt, der bis zu einer darunterliegenden Metallisierungsebene führen kann, ohne dort eine elektrische Verbindung herzustellen. Damit weist die Leiterbahn im Bereich der kritischen Stelle einen ausreichenden Querschnitt auf, so dass jegliche Instabilität der Leiterbahn bzw. deren Unterbrechung zuverlässig verhindert werden.

Beispielsweise können diese Dummy-Kontakte an kritischen Stellen vorgesehen sein, die durch eine Unterbrechung einer von zwei eng benachbarten parallelen Leiterbahnen bedingt sind.

Die Leiterbahnen können eine Breite von etwa 150 bis 250 nm haben und einen Abstand voneinander in der Größenordnung von etwa 130 bis 180 nm aufweisen.

Bei der erfindungsgemäßen integrierten Halbleiterschaltungsanordnung werden also an kritischen Stellen von Leiterbahnen Dummy-Kontakte vorgesehen. Durch diese Dummy-Kontakte werden an diesen kritischen Stellen die Querschnitte der Leiterbahn erhöht, so dass es nicht mehr zu Instabilitäten der Leiterbahn oder gar zu deren Abriss kommen kann. Auch werden erhöhte Elektromigrationsanfälligkeiten zuverlässig vermieden.

Durch den Einsatz der Dummy-Kontakte ist es so möglich, Layouts mit kritischen Geometrien, d.h. besonders kleinen Strukturen, vorzusehen, so daß die Erfindung eine weitere Miniaturisierung von integrierten Halbleiterschaltungsanordnungen begünstigt.

Die vorliegende Erfindung ist in besonders vorteilhafter Weise bei sogenannten Damascene- und Dual-Damascene-Metallisierungssystemen integrierter Schaltungen von Vorteil, da bei diesen Systemen die Dummy-Kontakte nicht nur eine lokale Aufweitung der Geometrie der Leiterbahn, sondern auch eine lokale Erhöhung des Leitungsquerschnittes zur Folge haben.

Gegebenenfalls kann die Erfindung auch bei anderen lithographisch definierten Metallisierungssystemen und nicht nur bei integrierten Schaltungen in vorteilhafter Weise eingesetzt werden.

Nachfolgend wird die Erfindung anhand der Zeichnungen näher erläutert. Es zeigen:
- Fig. 1: eine Draufsicht auf verschiedene Leiterbahnen mit Dummy-Kontakten gemäß der vorliegenden Erfindung,
- Fig. 2: einen Schnitt durch eine Leiterbahn mit einem Dummy-Kontakt gemäß der Erfindung,
- Fig. 3: einen Schnitt durch eine bestehende Leiterbahn und
- Fig. 4: eine Draufsicht auf Leiterbahnen zur Erläuterung des der Erfindung zugrundeliegenden Problems.

Die Fig. 3 und 4 sind bereits eingangs beschrieben worden. In den Figuren werden für einander entsprechende Bauteile mit den gleichen Bezugszeichen versehen.

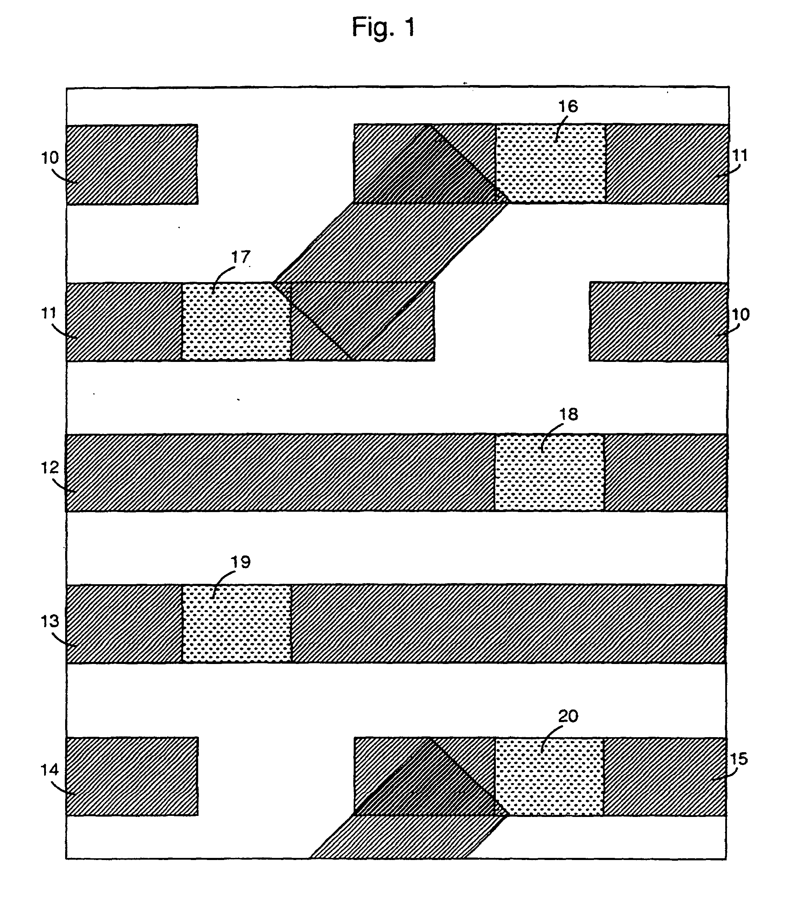

Fig. 1 zeigt in einer Draufsicht auf eine Metallisierungsebene Leiterbahnen 10 bis 15, von denen die Leiterbahnen 10, 11 sowie 14 und 15 einander jeweils in einem Twist-Bereich überkreuzen. Das heißt, die Leitung 10 ist in einer über der Metallisierungsebene der Fig. 1 liegenden weiteren Ebene im Abstand und getrennt durch eine Isolierschicht über die Leiterbahn 11 geführt. Die Leiterbahnen 12 und 13 sind dagegen durchgehende Leiterbahnen.

Die Leiterbahnen 14 und 15 weisen eine ähnliche Struktur wie die Leiterbahnen 10 und 11 auf.

Bei diesen Leiterbahnen 10 bis 15 kann es sich beispielsweise um Bitleitungen eines Speicherzellenfeldes handeln. Die Breite der Leiterbahnen liegt zwischen 150 bis 250 nm und beträgt vorzugsweise etwa 200 nm. Der Abstand zwischen den Leiterbahnen liegt zwischen 130 und 180 nm. Die Leiterbahnen selbst können aus Aluminium oder Kupfer oder sonstigen geeigneten Materialien bestehen.

Es hat sich gezeigt, daß bei der Metallisierung der Leiterbahnen 10 bis 15 infolge des Proximity-Effektes kritische Stellen dort entstehen, wo Diskontinuitäten in der Nachbarschaft der Leiterbahnen vorliegen. Solche Diskontinuitäten treten dann auf, wenn die benachbarte Leiterbahn unterbrochen ist. An diesen diskontinuierlichen Stellen weisen die Leiterbahnen Instabilitäten auf, die sogar zu einem Abriß der Leiterbahnen führen können.

Erfindungsgemäß sind nun an diesen kritischen Stellen Dummy-Kontakte 16 bis 20 vorgesehen, die zu einer unterhalb der Leiterbahnebene der Fig. 1 liegenden Ebene führen.

Fig. 2 zeigt einen Schnitt durch einen solchen Dummy-Kontakt, beispielsweise den Dummy-Kontakt 17. Die Leiterbahn 11 hat hier in folge der diskontinuierlichen Nachbarschaft einen verringerten Querschnitt, der, wie in Fig. 2 gezeigt ist, gegebenenfalls auch beidseitig auftreten kann. Zur Verstärkung der Leiterbahn 11 ist daher unterhalb von dieser der Dummy-Kontakt 17 vorgesehen, der eine Isolierschicht 5 aus Siliziumdioxid durchsetzt und bis zu einer tieferliegenden Leiterbahnebene 21 führt. Auf dieser Leiterbahnebene 21 können zusätzliche Leiterbahnen 22 verlaufen, die auf einer Siliziumdioxidschicht 23 liegen und von dem Dummy-Kontakt 17 elektrisch isoliert sind.

Wesentlich an der vorliegenden Erfindung ist also, daß Leiterbahnen an kritischen Stellen bewußt mit Dummy-Kontakten versehen werden, so daß eine Instabilität der Leiterbahn bzw. deren Abriß zuverlässig zu vermeiden sind. Diese Dummy-Kontakte brauchen selbstverständlich nicht bis zur nächsten Leiterbahnebene zu reichen. Es ist vielmehr ausreichend, wenn die Dummy-Kontakte einen solchen Querschnitt aufweisen, daß eine Instabilität bzw. ein Abriß der durch sie verstärkten Leiterbahn zuverlässig ausgeschlossen werden kann.

## Patentansprüche

1. Integrierte Halbleiterschaltungsanordnung mit in wenigstens zwei verschiedenen Ebenen verlaufenden Leiterbahnen (11 bis 15; 22), bei der in wenigstens einer der Ebenen Leiterbahnen (11 bis 15) in enger Nachbarschaft im Wesentlichen parallel zueinander vorgesehen sind,
**dadurch gekennzeichnet,**
**dass** die Leiterbahnen (11 bis 15) an Diskontinuitäten wenigstens einer benachbarten Leiterbahn durch einen Dummy-Kontakt (16 bis 20) unterlegt sind.

2. Integrierte Halbleiterschaltungsanordnung nach Anspruch 1,
**dadurch gekennzeichnet,**
**dass** die Diskontinuität durch eine Unterbrechung der eng benachbarten parallelen Leiterbahn bedingt ist.

3. Integrierte Halbleiterschaltungsanordnung nach Anspruch 1 oder 2,
**dadurch gekennzeichnet, daß** die Leiterbahnen eine Breite von 150 bis 250 nm haben.

4. Integrierte Halbleiterschaltungsanordnung nach Anspruch 3,
**dadurch gekennzeichnet, daß** die Leiterbahnen eine Breite von 200 nm haben.

5. Integrierte Halbleiterschaltungsanordnung nach einem der Ansprüche 1 bis 4,
**dadurch gekennzeichnet, daß** der Abstand zwischen den Leiterbahnen (11 bis 15) 130 bis 180 nm beträgt.

6. Integrierte Halbleiterschaltungsanordnung nach einem der Ansprüche 1 bis 5,
**dadurch gekennzeichnet, daß** die Leiterbahnen aus Aluminium oder Kupfer bestehen.

## Claims

1. Integrated semiconductor circuit arrangement having interconnects (11 to 15; 22) which run in at least two different planes, in which, in at least one of the planes, interconnects (11 to 15) are provided in close proximity essentially parallel to one another,
**characterized**
**in that** the interconnects (11 to 15) have a dummy contact (16 to 20) situated underneath them at discontinuities of at least one adjacent interconnect.

2. Integrated semiconductor circuit arrangement according to Claim 1,
**characterized**
**in that** the discontinuity is dictated by an interruption of the closely adjacent, parallel interconnect.

3. Integrated semiconductor circuit arrangement according to Claim 1 or 2,
**characterized in that**
the interconnects have a width of 150 to 250 nm.

4. Integrated semiconductor circuit arrangement according to Claim 3,
**characterized in that**
the interconnects have a width of 200 nm.

5. Integrated semiconductor circuit arrangement according to one of Claims 1 to 4,
**characterized in that**
the spacing between the interconnects (11 to 15) is 130 to 180 nm.

6. Integrated semiconductor circuit arrangement according to one of Claims 1 to 5,
**characterized in that**
the interconnects are composed of aluminum or copper.

## Revendications

1. Dispositif à semiconducteur intégré ayant des pistes conductrices (11 à 15 ; 22) qui s'étendent dans au moins deux plans différents et dans lequel il est prévu dans au moins l'un des plans des pistes conductrices (11 à 15 ) en voisinage étroit et sensiblement parallèles,
**caractérisé**
**en ce que** les pistes conductrices (11 à 15) sont mises sous des discontinuités d'au moins une piste conductrice voisine par un contact (16 à 20) fictif.

2. dispositif à semiconducteur intégré suivant la revendication 1,
**caractérisé**
**en ce que** la discontinuité est due à une interruption de la piste conductrice parallèle étroitement voisine.

3. Dispositif à semiconducteur intégré suivant la revendication 1 ou 2,
**caractérisé**
**en ce que** les pistes conductrices ont une largeur de 150 à 250 nm.

4. Dispositif à semiconducteur intégré suivant la revendication 3,
**caractérisé**
**en ce que** les pistes conductrices ont une largeur de 200 nm.

5. Dispositif à semiconducteur intégré suivant l'une des revendications 1 à 4,
**caractérisé**
**en ce que** la distance entre les pistes conductrices (11 à 15) est comprise entre 130 et 180 nm.

6. Dispositif à semi conducteur intégré suivant l'une des revendications 1 à 5,
**caractérisé**
**en ce que** les pistes conductrices sont en aluminium ou en cuivre.
